# EUROPEAN PATENT APPLICATION

(11) **EP 4 647 779 A1**
(43) Date of publication of application: **12.11.2025**
(21) Application number: 25171227.9
(22) Date of filing: 17.04.2025
(51) Int. Cl.: G01R 19/14, G01R 31/34, G01R 31/28, G01R 19/00

(54) **MONITORING CIRCUIT AND CORRESPONDING DC DRIVER AND METHOD**

(30) Priority: 08.05.2024 IT 202400010366
(71) Applicant: STMicroelectronics International N.V., 1228 Plan-les-Ouates, Geneva (CH)
(72) Inventor: COSTANZO, Lorenzo, I-95030 Gravina di Catania (Catania) (IT); PUNTORIERI, Veronica, I-95037 San Giovanni La Punta (Catania) (IT); MICCOLI, Leonardo Agatino, I-95030 Tremestieri Etneo (Catania) (IT)
(74) Representative: Buzzi, Notaro & Antonielli d'Oulx S.p.A.

(57) **Abstract**

Circuit (30; 30') for monitoring phases of a Direct Current, DC, driver, said DC driver being configured to drive a load via a first terminal and a second terminal coupled to respective load terminals switching a polarity there applied;
wherein said circuit (30; 30') comprises:
- a first comparison circuitry (AMP₁) configured to receive a first voltage (V_OUTₐ) of the first terminal and a threshold voltage (Vₜₕ), to compare said first voltage (V_OUTₐ) with said threshold voltage (Vₜₕ), obtaining a first comparison voltage, and to provide said first comparison voltage to a selection circuitry (PD_{a,b});
- a second comparison circuitry (AMP₂) configured to receive a second voltage (V_OUT_{b}) of the second terminal and said threshold voltage (Vₜₕ), to compare said second voltage (V_OUT_{b}) with said threshold voltage (Vₜₕ), obtaining a second comparison voltage, and to provide said second comparison voltage to the selection circuitry (PD_{a,b}); and
- the selection circuitry (PD_{a,b}) being configured to receive the first comparison voltage, the second comparison voltage, and a selection signal (SEL) indicating to select either the first comparison voltage or the second comparison voltage, and to select, based on said selection signal (SEL), said first comparison voltage or said second comparison voltage as a monitored voltage signal (P_{OUT}).

## Description

### Technical field

The description relates to monitoring circuits.

One or more embodiments can be applied to circuits for monitoring output phases in DC ("Direct Current") motor drivers.

### Background

DC ("Direct Current") motors are ubiquitous in various applications; therefore, efficient control and monitoring of these motors can improve their performance and safety, also extending their operational lifespan.

Such control and monitoring functions are usually implemented via DC motor drivers.

A DC motor driver is an interface between a control system, for instance, a microcontroller, and a respective DC motor that is to be driven.

Such DC motor drivers, in addition to being configured to provide control functions such as regulating and driving the DC motor, can also be configured to provide monitoring and protection functions, such as overcurrent or overvoltage detection.

Therefore, monitoring the functionality and operability of such DC motor drivers is of crucial importance for operating such DC motors correctly.

Known solutions related to circuits for monitoring DC motor drivers are based on current sensing operations, aiming at providing feedback related to control output currents of such DC motor drivers to respective microcontrollers, such output currents of the DC motor drivers being the currents flowing in respective DC motors in operation and used to drive such motors.

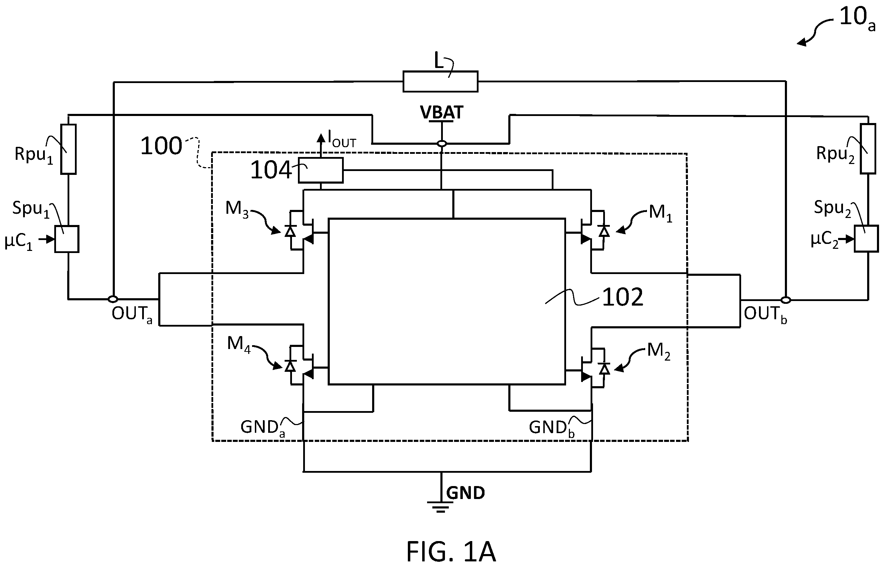

Figure 1A illustrates a block diagram of a known exemplary circuit 10ₐ for performing current sense monitoring operations and short circuit detection in DC motor drivers 100 coupled to a load L, for instance, a DC motor.

The DC motor driver 100 of Figure 1A is coupled to the load L, that is, the DC motor L, via a first output terminal OUTₐ and a second output terminal OUT_{b}, and is supplied with a voltage VBAT via a supply terminal.

The DC motor driver 100 comprises a logic control unit 102 coupled between the supply terminal at the voltage VBAT and a ground terminal GND, for instance, via a first ground terminal GNDₐ and a second ground terminal GND_{b}.

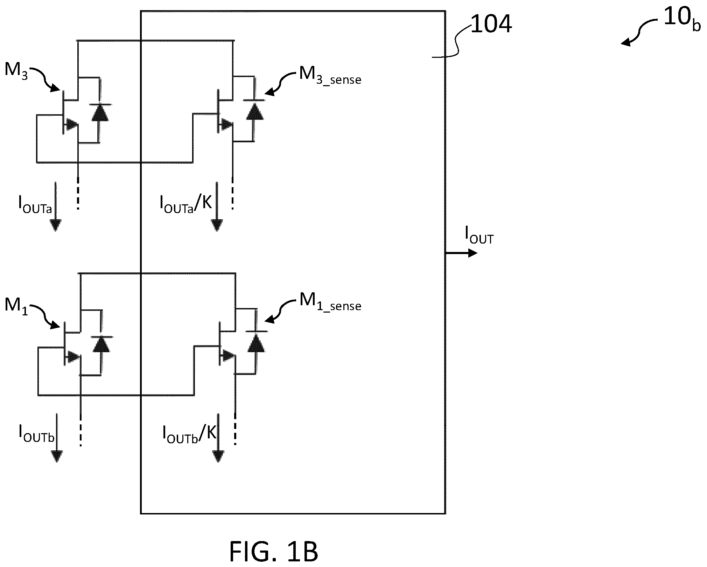

The DC motor driver 100 further comprises a full-bridge (that is, an H-bridge) circuit comprising:
- a first transistor, for instance, a MOSFET ("Metal-Oxide-Semiconductor Field-Effect Transistor") M₁ with a body diode, having its control terminal coupled to the logic control unit 102, its current sinking terminal coupled to the supply terminal, and its current source terminal coupled to the second output terminal OUT_{b} and configured to provide a first output current I_{OUTb} (see, for instance, Figure 1B);
- a second transistor, for instance, a MOSFET M₂ with a body diode, having its control terminal coupled to the logic control unit 102, its current sinking terminal coupled to the second output terminal OUT_{b}, and its current source terminal coupled to the ground terminal GND via the second ground terminal GND_{b};
- a third transistor, for instance, a MOSFET M₃ with a body diode, having its control terminal coupled to the logic control unit 102, its current sinking terminal coupled to the supply terminal, and its current source terminal coupled to the first output terminal OUTₐ and configured to provide a second output current I_{OUTa} (see, for instance, Figure 1B);
- a fourth transistor, for instance, a MOSFET M₄ with a body diode, having its control terminal coupled to the logic control unit 102, its current sinking terminal coupled to the first output terminal OUTₐ, and its current source terminal coupled to the ground terminal GND via the first ground terminal GNDₐ.

It is noted that the first output terminal OUTₐ and the second output terminal OUT_{b} are used to provide to such DC motor L the control output currents used to drive such DC motor L.

Such control output currents are sensed via a current monitoring circuit 104 coupled to the high sides of the H-bridge, for instance, to the current sinking terminal of the third transistor M₃ and to the current sinking terminal of the first transistor M₁, such current monitoring circuit 104 being configured to implement a current mirror via a split of cell of Power MOS.

Therefore, such current monitoring circuit 104 is configured to provide a monitoring output current I_{OUT} to a microcontroller, such monitoring output current I_{OUT} being indicative of a current flowing either in the current sinking terminal of the third transistor M₃ or in the current sinking terminal of the first transistor M₁, that is, indicative of the control output currents generated by the DC motor driver 100 that are provided to the DC motor L via the first output terminal OUTₐ and the second output terminal OUT_{b}.

It is noted that such monitoring output current I_{OUT} can only be provided during on states of the DC motor driver 100.

Then, the microcontroller may be configured to use, during an on-state of the DC motor driver 100, such feedback to implement operations related to diagnostic fault coverage.

An exemplary current monitoring circuit 104 is illustrated in Figure 1B, which illustrates a circuit 10_{b} for performing current sense monitoring operations coupled to a DC motor driver.

Such exemplary current monitoring circuit 104 may comprise:
- a first current sense transistor, for instance, a MOSFET ("Metal-Oxide-Semiconductor Field-Effect Transistor") M_{1_sense} with a body diode, having its control terminal coupled to the control terminal of the first transistor M₁, its current sinking terminal coupled to the current sinking terminal of the first transistor M₁, and its current source terminal coupled to an output terminal of the current monitoring circuit 104 and configured to provide as output a monitoring output current I_{OUT} equal to a first scaled monitoring output current I_{OUTb}/K that is the first output current I_{OUTb} scaled by a factor equal to K; and
- a second current sense transistor, for instance, a MOSFET M_{3_sense} with a body diode, having its control terminal coupled to the control terminal of the third transistor M₃, its current sinking terminal coupled to the current sinking terminal of the third transistor M₃, and its current source terminal coupled to an output terminal of the current monitoring circuit 104 and configured to provide as output a monitoring output current I_{OUT} equal to a second scaled monitoring output current I_{OUTa}/K that is the second output current I_{OUTa} scaled by a factor equal to K.

In addition, it is possible to provide a circuitry comprising:
- a first branch, for instance, a branch that is external to the DC motor driver 100, coupled between the first output terminal OUTₐ of the DC motor driver 100 and the supply terminal at the voltage VBAT, such first branch comprising a first pull-up resistor Rpu₁ and a first pull-up switch Spu₁ configured to be driven by a first signal µC₁ sent by a microcontroller; and
- a second branch, for instance, a branch that is external to the DC motor driver 100, coupled between the second output terminal OUT_{b} of the DC motor driver 100 and the supply terminal at the voltage VBAT, such second branch comprising a second pull-up resistor Rpu₂ and a second pull-up switch Spu₂ configured to be driven by a second signal µC₂ sent by the microcontroller.

Such pull-up resistors Rpu₁ and Rpu₂ and switches Spu₁ and Spu₂ driven by the microcontroller are used to provide further feedback related to short circuits, for instance, either to short circuit to battery VBAT or to short circuit to ground GND.

The standard ISO26262, which is the actual international standard related to functional safety of electrical and/or electronic systems that are installed in serial production road vehicles, defines minimum requirements for safety that are measured via the Automotive Safety Integrity Level (ASIL), a safety level determined through hazard analysis and risk assessment.

Such standard ISO26262, for instance, considering the ASIL-B metrics, requires that the functionality of the monitoring device, that is, the DC motor driver 100, is (preferably constantly) monitored in all operation mode, that is, both during the on-state and during an off-state of the DC motor driver 100.

Known solutions, as previously described, can monitor, that is, providing feedback to the microcontroller, DC motor drivers 100 only during their on-state, thus, not allowing a monitoring during their off-state and not reaching the required safety results.

Therefore, solutions that improve a monitoring of a device used for driving a DC motor, that is, a DC motor driver, facilitating performing monitoring operations, for instance, both during on-states and during off-states of such DC motor driver, would be beneficial in order to increase a functional safety of such device.

### Object and summary

An object of one or more embodiments is to contribute in providing solutions for improving a monitoring of a device used for driving a DC motor, that is, a DC motor driver, facilitating performing monitoring operations, for instance, both during on-states and during off-states of such DC motor driver.

According to one or more embodiments, that object is achieved via a circuit having the features set forth in the claims that follow.

One or more embodiments concern a corresponding method.

One or more embodiments concern a corresponding DC driver.

The claims are an integral part of the technical teaching provided in respect of the embodiments.

Solutions as described herein include a circuit for monitoring phases of a Direct Current, DC, driver, said DC driver being configured to drive a load via a first terminal and a second terminal coupled to respective load terminals switching a polarity there applied;
wherein said circuit comprises:
- a first comparison circuitry configured to receive a first voltage of the first terminal and a threshold voltage, to compare said first voltage with said threshold voltage, obtaining a first comparison voltage, and to provide said first comparison voltage to a selection circuitry;
- a second comparison circuitry configured to receive a second voltage of the second terminal and said threshold voltage, to compare said second voltage with said threshold voltage, obtaining a second comparison voltage, and to provide said second comparison voltage to the selection circuitry; and
- the selection circuitry being configured to receive the first comparison voltage, the second comparison voltage, and a selection signal indicating to select either the first comparison voltage or the second comparison voltage, and to select, based on said selection signal, said first comparison voltage or said second comparison voltage as a monitored voltage signal.

In various embodiments, said first comparison circuitry is configured to receive said first voltage via a first node; and said second comparison circuitry is configured to receive said second voltage via a second node;
wherein said circuit comprises:
- a first switch coupled between said first node and a supply terminal and/or a second switch coupled between said second node and said supply terminal, said first switch and said second switch being configured to perform pull-up operations; and/or
- a first pull-down impedance coupled between said first node and a ground terminal and/or a second pull-down impedance coupled between said second node and said ground terminal.

In various embodiments, said first switch and said second switch integrate a protection circuitry, in particular, wherein said first switch and said second switch are Vertical Intelligent Power, VIPower switches.

In various embodiments, said selection circuitry is configured to drive, based on a comparison voltage selected out of said first comparison voltage and said second comparison voltage, a transistor via its control terminal, said transistor having:
- its current source terminal coupled to a ground terminal; and
- its current sinking terminal configured to provide the monitored voltage signal.

In various embodiments, said monitored voltage signal is provided to a control unit, in particular, a control unit external to the DC driver, said control unit being configured to, based on a current operation mode of the DC driver:
- set the selection signal to indicate to select the first comparison voltage or the second comparison voltage;
- retrieve an expected monitored voltage level, in particular a binary level;
- compare the received monitored voltage signal with a verification voltage threshold, obtaining a comparison monitored voltage level, in particular a binary level, indicating if the received monitored voltage signal is higher or lower than the verification voltage threshold;

- if the comparison monitored voltage level is equal to the expected monitored voltage level, classify the current operation mode of the DC driver as not anomalous; and
- if the comparison monitored voltage level is different from the expected monitored voltage level, classify the current operation mode of the DC driver as anomalous.

In various embodiments, said control unit is configured to operate, based on the current operation mode of the DC driver the first switch and/or the second switch for performing pull-up operations.

In various embodiments, said DC driver comprises:
- a H-bridge comprising a plurality of transistors; and
- a DC driver control unit configured to drive, via respective control terminals, said plurality of transistors comprised in the H-bridge.

In various embodiments, said load is a DC motor.

In various embodiments, said circuit is integrated in the DC driver, in particular, in a DC driver control unit; or said circuit is external to the DC driver and, in particular, is implemented using discrete components.

Therefore, solutions as described herein facilitate improving the monitoring of devices used for driving DC motors, that is, DC motor drivers, facilitating performing monitoring operations, for instance, both during on-states and during off-states of such DC motor drivers, in order to increase a functional safety of such devices.

### Brief description of the figures

One or more embodiments will now be described, by way of example only, with reference to the annexed figures, wherein:
Figure 1A illustrates an exemplary block diagram of a circuit for performing current sense monitoring operations and short circuit detection in DC motor drivers coupled to a load;
Figure 1B illustrates an exemplary block diagram of a circuit for performing current sense monitoring operations coupled to a DC motor driver;
Figures 2 and 3 illustrate exemplary block diagrams of a circuit for performing phase monitoring operations in DC motor drivers coupled to a load according to embodiments of the present description;
Figure 4 and Figure 5 illustrate an exemplary circuit able to generate a feedback signal that allows monitoring operations on the phases of a DC motor driver according to embodiments of the present description; and
Figure 6 illustrates exemplary signals flowing in the circuit of Figure 4 or Figure 5 for generating the feedback signal that allows monitoring operations according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As previously described, solutions as described herein aim at facilitating improving the monitoring of devices used for driving DC ("Direct Current") motors, that is, DC motor drivers, facilitating performing monitoring operations, for instance, both during on-states and during off-states of such DC motor drivers, in order to increase a functional safety of such devices.

It is noted that, even if the following description is mainly focused on automotive applications, solutions as described herein may be used also in other applications where an improved monitoring of DC motor drivers is required.

Examples of possible applications comprising driving a DC motor that can use the solutions disclosed herein may be, for instance, automotive applications such as door locking, window lifting, powering lift gates, electric parking braking, seat adjustment, powering window, steering column, or the like.

In addition, it is noted that, even if the following description is mainly focused on a driver implemented via full-bridge architecture (that is, an H-bridge), such driver may also be implemented via any other architecture having two terminals coupled to respective terminals of a load and allowing to switch the polarity applied to such terminals of the load coupled thereto.

For instance, different solutions may consider two half-bridges ("H-bridges") used with legs parallelization to supply a load L, for instance, a motor.

For instance, other solutions may consider a cascade configuration, provided using two H-bridges for driving three loads L (such as motors), which are supplied by respective output pins. It is noted that in such a type of solution it is possible to supply one motor L at once.

It is also noted that, even if the following description is mainly focused on a load implemented via a DC motor, other loads that can be driven via two terminals using a switching polarity may also be considered.

It is noted that circuits for monitoring an output phase of DC motor drivers as described herein may be integrated within the same integrated circuit of such DC motor drivers.

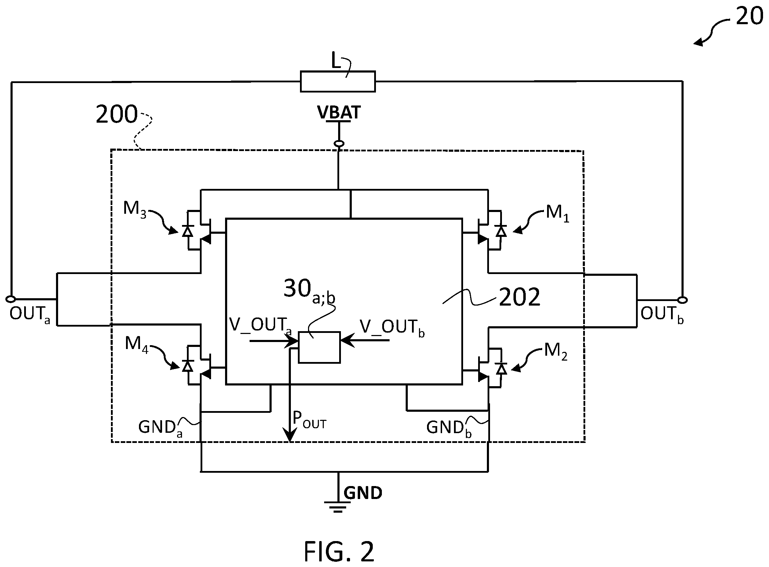

For instance, Figure 2 illustrates an exemplary block diagram 20 of a circuit 30 (either a circuit 30ₐ or 30_{b} as described in the following) for performing phase monitoring operations in DC drivers 200, for instance, DC motor drivers, coupled to respective loads L, for instance, DC motors, the DC motor driver 200 being configured to comprise the circuit 30 according to embodiments of the present description.

In particular, such circuit 30 may be comprised in a logic control unit 202 of the DC motor driver 200.

Alternatively, circuits for monitoring the output phase of DC motor drivers as described herein may be provided via elements that are external to such integrated circuit comprising the DC motor driver 200', for instance, by using discrete components.

It is also noted that such circuits for monitoring the output phase of DC motor drivers as described herein may be provided via elements that are comprised in the integrated circuit comprising the DC motor driver 200' but are external to a logic control unit 202' of the DC motor driver 200'.

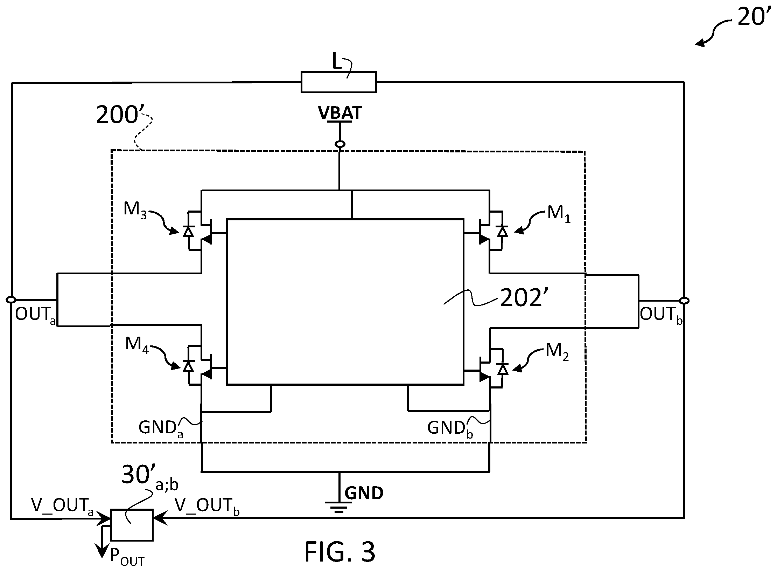

For instance, Figure 3 illustrates an exemplary block diagram 20' of a circuit 30' (either a circuit 30'ₐ or 30'_{b} as described in the following) for performing phase monitoring operations in DC drivers 200', for instance, DC motor drivers, coupled to respective loads L, for instance, DC motors, the circuit 30' being configured to be external to the DC motor driver 200' (and, for instance, to be composed by discrete components) according to embodiments of the present description.

Hence, solutions as described herein aim at providing, for instance, to an additional control unit such as a microcontroller, a microprocessor, a logic unit, or the like, a monitoring signal P_{OUT}, that is, a feedback signal.

Such monitoring signal P_{OUT}, preferably a real-time feedback signal, can be available both during on-states and during off-states of the DC motor driver 200 or 200' and is configured to provide feedback related to the output status of the DC motor driver 200 or 200' and, in particular, to an output phase of such DC motor driver.

Therefore, the additional control unit may be further configured to detect, using the received monitoring signal P_{OUT}, and to react to anomalous or faulty conditions.

To this purpose, circuits 30 and 30' used to monitor the output phases of DC motor drivers are configured to sense the output voltages of the power stages of such DC motor drivers, for instance, a first voltage V_OUTₐ is sensed from a first output terminal OUTₐ and a second voltage V_OUT_{b} is sensed from a second output terminal OUT_{b}, and to compare such sensed output voltages V_OUTₐ and V_OUT_{b} with a given threshold voltage Vₜₕ, for instance, a fixed threshold voltage.

The result of such comparison operation is related to the power status of a DC motor diver 200 or 200' and may correspond to the monitoring signal P_{OUT}, thus, being the feedback of the output status, that is, a phase of the DC motor driver, provided to the additional control unit, for instance, via a phase output terminal.

The DC driver 200, for instance, the DC motor driver, of Figure 2 is coupled to the load L, for instance, the DC motor L, via the first output terminal OUTₐ and the second output terminal OUT_{b}, and is supplied with a voltage VBAT via a supply terminal.

The DC motor driver 200 comprises a logic control unit 202 coupled between the supply terminal at the voltage VBAT and a ground terminal GND, for instance, via a first ground terminal GNDₐ and a second ground terminal GND_{b}.

The DC motor driver 200 further comprises a full-bridge circuit comprising:
- a first transistor, for instance, a MOSFET ("Metal-Oxide-Semiconductor Field-Effect Transistor") M₁ with a body diode, having its control terminal coupled to the logic control unit 202, its current sinking terminal coupled to the supply terminal, and its current source terminal coupled to the second output terminal OUT_{b};
- a second transistor, for instance, a MOSFET M₂ with a body diode, having its control terminal coupled to the logic control unit 202, its current sinking terminal coupled to the second output terminal OUT_{b}, and its current source terminal coupled to the ground terminal GND via the second ground terminal GND_{b};
- a third transistor, for instance, a MOSFET M₃ with a body diode, having its control terminal coupled to the logic control unit 202, its current sinking terminal coupled to the supply terminal, and its current source terminal coupled to the first output terminal OUTₐ;
- a fourth transistor, for instance, a MOSFET M₄ with a body diode, having its control terminal coupled to the logic control unit 202, its current sinking terminal coupled to the first output terminal OUTₐ, and its current source terminal coupled to the ground terminal GND via the first ground terminal GNDₐ.

It is noted that the first output terminal OUTₐ and the second output terminal OUT_{b} are used to provide to such DC motor L the control output currents used to drive such DC motor L.

The first output terminal OUTₐ and the second output terminal OUT_{b} are coupled, via a voltage sensing circuitry comprised in the DC motor driver 200, to a circuit 30.

Therefore, such circuit 30, comprised in the DC motor driver 200, is configured to receive the first voltage V_OUTₐ sensed from the first output terminal OUTₐ and the second voltage V_OUT_{b} sensed from the second output terminal OUT_{b}, to determine a monitoring signal P_{OUT} related to an output phase of the DC motor driver 200, and to provide such monitoring signal P_{OUT} to a phase output terminal of the DC motor driver 200.

The monitoring signal P_{OUT} may be retrieved by an additional control unit, for instance, a microcontroller, a microprocessor, a logic unit, or the like, from such phase output terminal of the DC motor driver in order to implement operations related to diagnostic fault coverage, such as detecting, based on such monitoring signal P_{OUT}, and reacting to failures.

It is noted that Figure 3 comprises same parts, elements, and/or components of Figure 2, except for the fact that the circuit 30 (referred to as 30' in Figure 3) is external to the DC driver 200 (referred to as 200' in Figure 3 to underline the fact that it do not comprise the circuit 30), for instance, the DC motor driver, therefore, such parts, elements, and/or components which have already been described with reference to Figure 2 will not be described again in order to avoid overburdening the present description.

The first output terminal OUTₐ and the second output terminal OUT_{b} are coupled, via a voltage sensing circuitry not comprised in the DC motor driver 200', to a circuit 30'.

Therefore, such circuit 30', not comprised in the DC motor driver 200', is configured to receive the first voltage V_OUTₐ sensed from the first output terminal OUTₐ and the second voltage V_OUT_{b} sensed from the second output terminal OUT_{b}, to determine a monitoring signal P_{OUT} related to an output phase of the DC motor driver 200', and to provide such monitoring signal P_{OUT} to a phase output terminal of the circuit 30'.

The monitoring signal P_{OUT} may be retrieved by an additional control unit, for instance, a microcontroller, a microprocessor, a logic unit, or the like, from such phase outputterminal of the circuit 30' in order to implement operations related to diagnostic fault coverage, such as detecting, based on such monitoring signal P_{OUT}, and reacting to failures.

It is noted that if the circuit 30' is comprised in the DC motor driver 200' but is external to the logic control unit 202' of the DC motor driver 200', the monitoring signal P_{OUT} may be provided to a phase output terminal of the DC motor driver 200' and the voltage sensing circuitry may either be comprised or not comprised in such DC motor driver 200'.

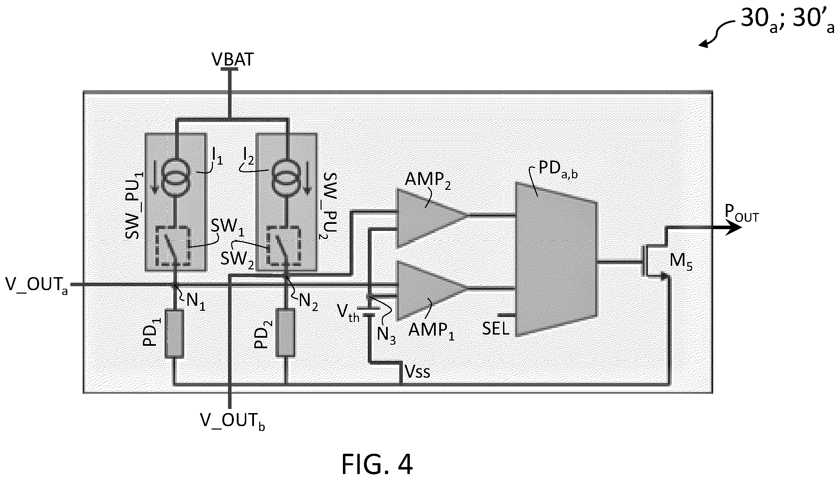

Figure 4 illustrates an exemplary circuit 30ₐ, 30'ₐ able to generate a feedback signal, that is, the monitoring signal P_{OUT}, that allows monitoring operations on the phases of a DC motor driver according to embodiments of the present description.

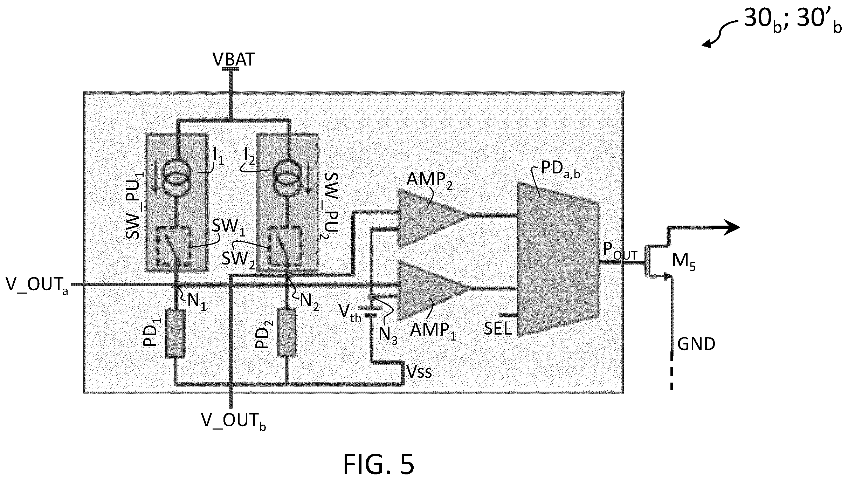

It is noted that most of the elements of Figure 4 are also present in Figure 5, which illustrates an exemplary circuit 30_{b}, 30'_{b} able to generate a feedback signal, that is, the monitoring signal P_{OUT}, that allows monitoring operations on the phases of a DC motor driver according to embodiments of the present description.

To this regard, the elements described in the following refers both to Figure 4 and Figure 5, thus, such exemplary circuit is generally referred to as circuit 30 or 30'.

Circuits for monitoring the output phases of DC motor drivers as described herein 30, 30' may comprise a selection unit PD_{a,b}, for instance, implemented via a multiplexer, and a plurality of switches SW comprising pull-up impedances SW_PU₁ and SW_PU₂.

Such selection unit PD_{a,b} and, if present, such plurality of switches SW, are configured to provide the power stage state monitoring function (that is, the monitoring of the phases of the DC motor driver via the feedback signal - that is, the monitoring signal P_{OUT}) during both on-states and off-states of the DC motor driver 200 or 200', and, more in general, in various working conditions of the full-bridge circuit.

It is noted that solutions as described herein may provide a feedback signal, that is, the monitoring signal P_{OUT}, related to the first voltage V_OUTₐ sensed from the first output terminal OUTₐ and the second voltage V_OUT_{b} sensed from the second output terminal OUT_{b}, thus, related to the phases of the DC motor driver 200 or 200', to the additional control unit, for instance, in real-time, during an operative mode of the DC motor driver 200 or 200'.

It is noted that the operative modes of the DC motor driver 200 or 200' may comprise a clock mode, a counter clock mode, a braking to voltage VBAT mode, and a braking to ground GND mode.

It is noted that during the operative modes, such monitoring signal P_{OUT} may be obtained without operating the plurality of switches SW.

It is noted that such plurality of switches SW comprising pull-up impedances SW_PU₁ and SW_PU₂ is operated if diagnostic operations are to be performed, for instance, operations for detecting a faulty component, that is, a fault detection function.

Therefore, solutions as described herein may provide, during fault detection conditions, a fault detection function that allows detecting a faulty component based on the states, that is, conductive or non-conductive, of the pull-up SW_PU₁ and SW_PU₂ impedance switches.

For instance, such fault detection function may allow to detect if a transistor out of the first transistor M₁, the second transistor M₂, the third transistor M₃, and the fourth transistor M₄ remains permanently in an on-state, that is, in a conductive state, or in an off-state, that is, in a non-conductive state, independently from an input state, that is, the state of the transistor set by the DC motor driver in order to drive the respective DC motor, being an on-state or an off-state.

In addition, solutions as described herein, using the circuit 30 or 30', may be able to follow the toggling of the first voltage V_OUTₐ sensed from the first output terminal OUTₐ and the second voltage V_OUT_{b} sensed from the second output terminal OUT_{b} up to a frequency of about 20kHz.

The circuits for monitoring the output phases of DC motor drivers 30, 30' may comprise, as previously described, the plurality of switches SW comprising pull-up impedances SW_PU₁ and SW_PU₂, wherein:
- a first pull-up impedance switch SW_PU₁, for instance, implemented via a dual monolithic high-side driver (comprising, for example, a first current source I₁ and a first switch SW₁, for instance, implementable via a transistor), may be coupled between a supply terminal at the voltage VBAT and a first node N₁; and
- a second pull-up impedance switch SW_PU₂, for instance, implemented via a dual monolithic high-side driver (comprising, for example, a second current source I₂ and a second switch SW₂, for instance, implementable via a transistor), may be coupled between the supply terminal at the voltage VBAT and a second node N₂.

The circuits for monitoring the output phases of DC motor drivers 30, 30' may further comprise:
- a first pull-down impedance PD₁ that may be coupled between the first node N₁ and an internal ground terminal supplied with a voltage Vss;
- a second pull-down impedance PD₂ that may be coupled between the second node N₂ and the internal ground terminal supplied with the voltage Vss;

It is noted that the plurality of switches SW may also be implemented via VIPower ("Vertical Intelligent Power") technologies, allowing to integrate on a same die a Power MOSFET with an intelligent signal/protection circuitry.

It is noted that the plurality of switches SW is configured to pull-up, via the first pull-up impedance switch SW_PU₁ and the second pull-up impedance switch SW_PU₂ the power outputs, that is, the first node N₁ and/or the second node N₂.

The first node N₁ may be configured to be supplied with the first voltage V_OUTₐ sensed from the first output terminal OUTₐ, while the second node N₂ may be configured to be supplied with the second voltage V_OUT_{b} sensed from the second output terminal OUT_{b}.

The first node N₁ may be coupled to a first input terminal of a first comparator AMP₁, such first comparator AMP₁ being configure to perform a comparison operation.

A second input terminal of the first comparator AMP₁ may be coupled to a third node N₃ supplied with a threshold voltage Vₜₕ, for instance, implemented via a voltage supply coupled between such third node N₃ and the internal ground terminal supplied with the voltage Vss.

An output terminal of the first comparator AMP₁ may be coupled to a first input terminal of the selection unit PD_{a,b}, such output terminal being configured to provide to the selection unit PD_{a,b} a result of a comparison between such first voltage V_OUTₐ received from the first node N₁ and the threshold voltage Vₜₕ received from the third node N₃.

Similarly, the second node N₂ may be coupled to a first input terminal of a second comparator AMP₂, such second comparator AMP₂ being configure to perform a comparison operation.

A second input terminal of the second comparator AMP₂ may be coupled to the third node N₃ supplied with the threshold voltage Vₜₕ.

An output terminal of the second comparator AMP₂ may be coupled to a second input terminal of the selection unit PD_{a,b}, such output terminal being configured to provide to the selection unit PD_{a,b} a result of a comparison between such second voltage V_OUT_{b} received from the second node N₂ and the threshold voltage Vₜₕ received from the third node N₃.

The selection unit PD_{a,b} may be configured to receive, at a selection input terminal, a selection signal SEL, indicating to couple the first input terminal of the selection unit PD_{a,b} or the second input terminal of the selection unit PD_{a,b} with an output terminal of the selection unit PD_{a,b}, thus, indicating to provide as output either the result of the comparison between the first voltage V_OUTₐ and the threshold voltage Vₜₕ, that is, an information related to a phase of the first output terminal OUTₐ, or the result of the comparison between the second voltage V_OUT_{b} and the threshold voltage Vₜₕ, that is, an information related to a phase of the second output terminal OUT_{b}, respectively.

In embodiments such as that illustrated in Figure 5, such output terminal of the selection unit PD_{a,b} may be provided as output of either the circuit 30'_{b} or, if the circuit 30_{b} is considered, of the DC motor driver 200, thus, being the feedback signal, that is, the monitoring signal P_{OUT}. It is noted that in such embodiments, a fifth transistor M₅ illustrated in such Figure 5 may also not be present.

It is noted that if such fifth transistor M₅ is present in embodiments as that of Figure 5, such fifth transistor M₅ may be configured to have:
- its current sinking terminal coupled, for instance, via a resistor, to an external voltage supply (not shown in Figure 5);
- its current source terminal coupled to an external ground terminal GND; and
- its control terminal coupled to the output terminal of the selection unit PD_{a,b}.

It is noted that such fifth transistor M₅ may be configured as an "open drain/collector" transistor, thus, being configured to act as an inverting switch that:
- when is switched on as a result of being driven via the output terminal of the selection unit PD_{a,b}, a short circuit is formed between the external voltage supply and the external ground terminal GND, therefore, outputting via its current sinking terminal a low impedance voltage signal; and
- when is switched off as a result of being driven via the output terminal of the selection unit PD_{a,b}, an open circuit is formed, therefore, outputting via its current sinking terminal a high impedance voltage signal.

Alternatively, in embodiments such as that illustrated in Figure 4, such output terminal of the selection unit PD_{a,b} may be configured to drive a fifth transistor, for instance, a MOSFET M₅, via its control terminal, such fifth transistor M₅ being comprised in the circuit 30ₐ or 30'ₐ.

A current source terminal of such fifth transistor M₅ is coupled to the internal ground terminal supplied with the voltage Vss and a current sinking terminal of such fifth transistor M₅ is the terminal supplying the feedback signal, that is, the monitoring signal P_{OUT}, to the additional control unit, either via the phase output terminal of the circuit 30'ₐ or, if the circuit 30ₐ is considered, via the phase output terminal of the DC motor driver 200.

Even in embodiments as that of Figure 4, such current sinking terminal of such fifth transistor M₅ may be coupled, for instance, via a resistor, to an external voltage supply (not shown in Figure 4).

Therefore, even in embodiments according to Figure 4, such fifth transistor M₅ may be configured as an "open drain/collector" transistor, thus, being configured to act as an inverting switch that:
- when is switched on as a result of being driven via the output terminal of the selection unit PD_{a,b}, a short circuit is formed between the external voltage supply and the internal ground terminal supplied with the voltage Vss, therefore, outputting via its current sinking terminal a low impedance voltage signal; and
- when is switched off as a result of being driven via the output terminal of the selection unit PD_{a,b}, an open circuit is formed, therefore, outputting via its current sinking terminal a high impedance voltage signal.

To summarize, solutions as disclosed herein are related to a circuit 30 or 30' for monitoring phases of driving signals outputted by a Direct Current, DC, driver 200 or 200' respectively, for instance, a driving signal used to drive a corresponding DC motor L, therefore, allowing the monitoring of the phase of such DC motor L.

Such DC driver 200 or 200' is configured to drive a load L, for instance, a DC motor but also other loads can be considered (as described above), via a first terminal, that is, the first output terminal OUTₐ, and a second terminal, that is, the second output terminal OUT_{b}, coupled to respective load terminals, and to switch a polarity applied thereon (that is, the polarity applied on the first output terminal OUTₐ and the second output terminal OUT_{b}).

Such circuit 30 or 30' comprises:
- a first comparison circuitry, for instance, the first comparator AMP₁, configured to receive a first voltage V_OUTₐ of the first terminal OUTₐ and a threshold voltage Vₜₕ, to compare such first voltage V_OUTₐ with such threshold voltage Vₜₕ, obtaining a first comparison voltage, that is, the result of the comparison provided by the first comparator AMP₁ via its output terminal, and to provide such first comparison voltage to a selection circuitry, for instance, the selection unit PD_{a,b};
- a second comparison circuitry, for instance, the second comparator AMP₂, configured to receive a second voltage V_OUT_{b} of the second terminal OUT_{b} and such threshold voltage Vₜₕ, to compare such second voltage V_OUT_{b} with such threshold voltage Vₜₕ, obtaining a second comparison voltage, that is, the result of the comparison provided by the second comparator AMP₂ via its output terminal, and to provide such second comparison voltage to the selection circuitry PD_{a,b}; and
- the selection circuitry PD_{a,b} being configured to receive the first comparison voltage, the second comparison voltage, and a selection signal SEL indicating to select either the first comparison voltage or the second comparison voltage, and to select, based on such selection signal SEL, such first comparison voltage or such second comparison voltage as a monitored voltage signal, that is, the monitoring signal P_{OUT}.

In addition, in embodiments of solutions disclosed herein, such first comparison circuitry AMP₁ may be configured to receive such first voltage V_OUTₐ via a first node N₁, and such second comparison circuitry AMP₂ may be configured to receive such second voltage V_OUT_{b} via a second node N₂.

In such a case, the circuit 30 or 30' may comprise:
- a first switch, for instance, the first pull-up impedance switch SW_PU₁, coupled between such first node N₁ and a supply terminal, for instance, the terminal at the voltage VBAT, and/or a second switch, for instance, the second pull-up impedance switch SW_PU₂, coupled between such second node N₂ and such supply terminal VBAT, such first switch SW_PU₁ and such second switch SW_PU₂ being configured to perform pull-up operations; and/or
- a first impedance, for instance, the first pull-down impedance PD₁, coupled between such first node N₁ and a ground terminal, for instance, the internal ground terminal supplied with the voltage Vss, and/or a second impedance, for instance, the second pull-down impedance PD₂, coupled between such second node N₂ and such ground terminal Vss.

In embodiments of solutions disclosed herein, such first switch SW_PU₁ and such second switch SW_PU₂ may integrate a protection circuitry, in particular, such first switch SW_PU₁ and such second switch SW_PU₂ may be Vertical Intelligent Power, VIPower switches.

In embodiments of solutions disclosed herein, such selection circuitry PD_{a,b} may be configured to drive, based on a comparison voltage selected out of such first comparison voltage and such second comparison voltage, a transistor, for instance, the fifth transistor M₅, via its control terminal, such transistor M₅ having:
- its current source terminal coupled to a ground terminal Vss; and
- its current sinking terminal configured to provide the monitored voltage signal P_{OUT}.

In embodiments of solutions disclosed herein, the DC driver 200 or 200' may comprise:
- a H-bridge comprising a plurality of transistors, for instance, the first transistor M₁, the second transistor M₂, the third transistor M₃, and the fourth transistor M₄; and
- a DC driver control unit, for instance, the logic control unit 202, configured to drive, via respective control terminals, such plurality of transistors M₁, M₂, M₃, and M₄ comprised in the H-bridge.

In embodiments of solutions disclosed herein, the load L coupled to the DC driver 200 or 200' may be a DC motor.

In embodiments of solutions disclosed herein, the circuit 30, 30' may be:
- integrated in the DC driver, for instance, the DC motor driver 200, in particular, in a DC driver control unit, for instance, in the logic control unit 202 (referring, for instance, to Figure 2); or
- external to the DC driver, for instance, the DC motor driver 200' (referring, for instance, to Figure 3) and, in particular, can be implemented using discrete components.

It is noted that the selection signal SEL may be provided by the additional control unit, for instance, a microcontroller or the like, according to the phase that is to be monitored, if the DC motor driver is in an operative mode, or to the fault that is to be detected, if the DC motor driver is in a fault detection condition.

The additional control unit may be configured to provide monitoring and protection functions by retrieving, based on:
- the value of the selection signal SEL, that is, indicating to couple either the first input terminal of the selection unit PD_{a,b} or the second input terminal of the selection unit PD_{a,b} with an output terminal of the selection unit PD_{a,b}, and
- the phase that is to be monitored, if the DC motor driver is in an operative mode, or to the fault that is to be detected, if the DC motor driver is in a fault detection condition,
an expected level, for instance, a (preferably binary) level determined based on a table stored in a memory, and a verification voltage threshold, for instance, stored in a memory of the additional control unit or outside such additional control unit.

The additional control unit may be further configured to:
- compare the received feedback signal with the verification voltage threshold, obtaining a comparison monitored voltage level, preferably a binary level, indicating if the received feedback signal is higher or lower than the verification voltage threshold; and
- verify that the obtained comparison monitored voltage level is equal to such retrieved expected level.

It is noted that such verification voltage threshold may be chosen in order to be higher than a voltage equal to zero and lower than the minimum voltage of the received feedback signal when such received feedback signal is related to an active state, that is, a high voltage level state such as the first given voltage V₁ of Figure 5, of the corresponding first voltage V_OUTₐ or second voltage V_OUT_{b} that is monitored.

In addition, the additional control unit may be further configured to:
- classify a current operation mode, that is, either a considered operative mode or a considered fault detection condition, of the DC driver as not anomalous if the obtained comparison monitored voltage level is equal to the retrieved expected level; and
- classify the current operation mode of the DC driver as anomalous id the obtained comparison monitored voltage level is different from the retrieved expected level.

It is noted that if the DC motor driver is in a fault detection condition, the plurality of switches SW can be operated based on the fault that is to be detected, for instance, via an internal logic configured to manage such plurality of switches SW according to switch states related to the fault that is to be detected, for instance, provided by the additional control unit on the base of data stored in such table.

It is noted that even the selection signal SEL provided by the additional control unit may be set according to a selection value, for instance, stored in such table.

If an anomalous condition is detected (either in the operative mode or in the fault detection mode), the additional control unit may be configured to provide a reaction for limiting the effects of such detected anomalous condition.

Therefore, such monitoring signal P_{OUT} can provide both a static and dynamic feedback to the additional control unit for facilitating performing safety-relevant functions, such feedback being indicative of the state of such first output terminal OUTₐ and such second output terminal OUT_{b}.

Such safety-relevant functions may comprise, for instance, the fault detection function described previously.

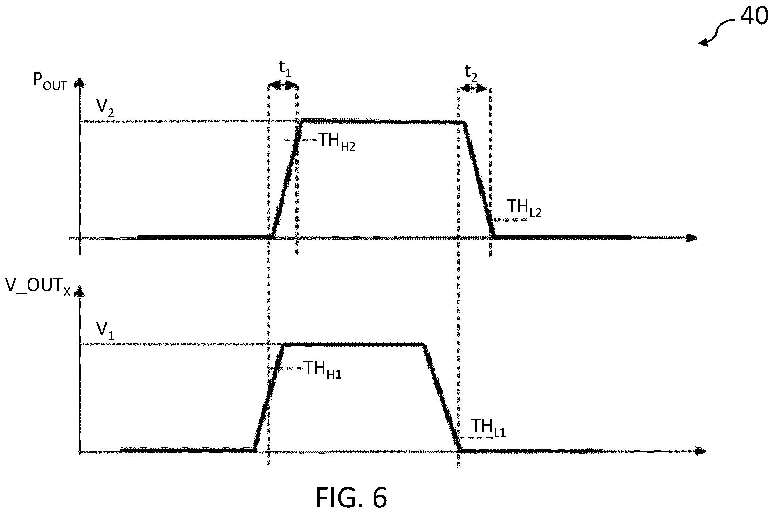

Figure 6 illustrates exemplary signals 40 flowing during the operative mode of the circuit 30, 30' of Figure 4 according to embodiments of the present description.

Figure 6 illustrates an exemplary behavior of a sensed voltage V_OUTₓ, corresponding to the first voltage V_OUTₐ sensed from the first output terminal OUTₐ and/or the second voltage V_OUT_{b} sensed from the second output terminal OUT_{b}, that:
- starts from a ground voltage,
- rises up to a first given voltage V₁, reaching a first high threshold TH_{H1}, for instance, indicating the 90% of the first given voltage V₁, and
- falls again to the ground voltage, reaching a first low threshold TH_{L1}, for instance, indicating the 10% of the first given voltage V₁.

Therefore, being the circuit 30 or 30' operating in the operative mode, the feedback signal, that is, the monitoring signal P_{OUT}, is related to such sensed voltage V_OUTₓ, corresponding to the first voltage V_OUTₐ sensed from the first output terminal OUTₐ and/or the second voltage V_OUT_{b} sensed from the second output terminal OUT_{b}, thus, such monitoring signal P_{OUT} is a voltage signal that:
- starts from a ground voltage,
- rises up to a second given voltage V₂, such second given voltage V₂ being different from the first given voltage V₁ as a result of the comparison operation performed between the first voltage V_OUTₐ or the second voltage V_OUT_{b} and the threshold voltage Vₜₕ (optionally, provided to the fifth transistor M_{5_}configured to invert the logic function of the received signal, as described above), reaching a second high threshold TH_{H2}, for instance, indicating the 90% of the second given voltage V₂, and
- falls again to the ground voltage, reaching a second low threshold TH_{L2}, for instance, indicating the 10% of the second given voltage V₂.

Therefore, such monitoring signal P_{OUT}, that is, the waveform of such signal, follows, that is, is correlated to, the behavior, that is, the waveform, of the sensed voltage V_OUTₓ, for instance, after a given delay that is illustrated in Figure 6 with the references t₁ and t₂, thus, providing to the additional control unit information related to the output status of the DC motor driver, that is, related to a phase of the DC motor driver.

Each operative and/or diagnostic condition that is to be analyzed, that is, each condition considered in solutions as described herein, may be characterized by:
- an expected level related to the monitoring signal P_{OUT}, for instance, an expected binary logic level related to the state of such signal P_{OUT};
- respective switch states (if the plurality of switches SW is present), for instance, respective switch states related to a fault that is to be detected by a considered diagnostic condition; and
- a selection value for the selection signal SEL, for instance, stored in a table.

In the following, exemplary operative and diagnostic conditions and respective values for the expected level related to the monitoring signal P_{OUT}, the respective switch states related to a fault that is to be detected, and the respective selection value for the selection signal SEL are described.

It is noted that such respective switch states may not be present in embodiments where the plurality of switches SW is not present.

It is noted that operative and diagnostic conditions different from those reported herein may also be present.

Such exemplary operative and diagnostic conditions and respective values for the expected level related to the monitoring signal P_{OUT}, the respective switch states related to a fault that is to be detected, and the respective selection value for the selection signal SEL may be stored in a table managed by the additional control unit.

The additional control unit may, for instance, based on the values comprised in the table and on a current mode of the DC motor driver, that is, either an operative mode or a fault detection mode and, in this last case, based also on the type of fault that is to be detected, be configured to:
- set the selection signal SEL to the selection value;
- operate the plurality of switches SW, if present, according to the switch states;
- retrieve the expected level for the monitoring signal P_{OUT} to check the equality as previously described; and/or
- configure the DC motor driver 200 or 200' in order to operate the first transistor M₁, the second transistor M₂, the third transistor M₃, and/or the fourth transistor M₄ based on the considered operative mode or the considered fault detection mode.

Therefore, such additional control unit may be further configured to, based on:
- the selection value set for the selection signal SEL, and
- the phase that is to be monitored or to the fault that is to be detected, considering also the switch states used to operate the plurality of switches SW (if present), retrieve the expected level corresponding to a current condition (or mode) and the voltage verification threshold, to compare the received feedback signal, that is, the monitoring signal P_{OUT}, with such retrieved voltage verification threshold, obtaining the comparison monitored voltage level, that is, a level indicating if the received feedback signal is higher or lower than the voltage verification threshold, and to determine that the current condition is:
- a normal condition, that is, a condition not affected by anomalous behaviors or faults, if the obtained comparison monitored voltage level is equal to the retrieved expected level; or
- an anomalous condition, for instance, a condition affected by faults, if the obtained comparison monitored voltage level is different from the retrieved expected level.

To summarize, circuits 30 or 30' as described herein may provide the monitored voltage signal P_{OUT} to a control unit, in particular, a control unit external to the DC driver 200 or 200'.

Such control unit may be configured to, based on a current operation mode, that is, based on the phase that is to be monitored (if the DC motor driver is in an operative mode) or the fault that is to be detected (if the DC motor driver is in a fault detection condition), either of the DC driver 200 or 200':
- set the selection signal SEL to indicate to select the first comparison voltage or the second comparison voltage;
- retrieve an expected monitored voltage level, in particular a binary level, that is, an expected level related to the monitored voltage signal P_{OUT};
- compare the received monitored voltage signal P_{OUT} with a verification voltage threshold, obtaining a comparison monitored voltage level, in particular a binary level, indicating if the received monitored voltage signal is higher or lower than the verification voltage threshold;
- if the comparison monitored voltage level is equal to the expected monitored voltage level, classify the current operation mode of the DC driver 200 or 200' as not anomalous, that is, a normal condition as described above; and
- if the comparison monitored voltage level is different from the expected monitored voltage level, classify the current operation mode of the DC driver 200 or 200' as anomalous.

In various embodiments, if the plurality of switches SW is present, such control unit may be configured to operate, based on the current operation mode of the DC driver 200 or 200' the first switch SW_PU₁ and/or the second switch SW_PU₂ for performing pull-up operations.

A first operative condition may be related to the monitoring of the first voltage V_OUTₐ sensed from the first output terminal OUTₐ of the DC motor driver 200 or 200' while the DC motor L is operated clockwise.

Such first operative condition can be obtained by:
- setting the selection signal SEL to indicate to couple the first input terminal of the selection unit PD_{a,b} to the output terminal of such selection unit PD_{a,b}, thus, indicating to provide as output the information related to the phase of the first output terminal OUTₐ, for instance, by setting such selection signal SEL to a binary logic level equal to a high logic level;
- avoid operating the plurality of switches SW;
- setting the expected level for the monitoring signal P_{OUT} equal to a sequence (even composed by a single value) of levels related to the first voltage V_OUTₐ sensed from the first output terminal OUTₐ during a normal (that is, not anomalous or faulty) clockwise operation of the DC motor L; and
- configuring the DC motor driver 200 or 200' in order to operate the first transistor M₁, the second transistor M₂, the third transistor M₃, and/or the fourth transistor M₄, that is, the full-bridge, in order to drive the DC motor L clockwise, for instance, by making the second transistor M₂ and the third transistor M₃ conductive and the first transistor M₁ and the fourth transistor M₄ non-conductive.

It is noted that other conditions described in the following that are related to the monitoring of the first voltage V_OUTₐ sensed from the first output terminal OUTₐ of the DC motor driver 200 or 200' comprise setting the selection signal SEL in order to indicate to couple the first input terminal of the selection unit PD_{a,b} to the output terminal of such selection unit PD_{a,b}, thus, indicating to provide as output the information related to the phase of the first output terminal OUTₐ, for instance, by setting such selection signal SEL to a binary logic level equal to a high logic level.

Therefore, such setting operation of the selection signal SEL will be not repeated in the following.

A second operative condition may be related to the monitoring of the first voltage V_OUTₐ sensed from the first output terminal OUTₐ of the DC motor driver 200 or 200' while the DC motor L is operated counter clockwise.

Such second operative condition can be obtained by, in addition to setting the selection signal SEL:
- avoid operating the plurality of switches SW;
- setting the expected level for the monitoring signal P_{OUT} equal to a sequence (even composed by a single value) of levels related to the first voltage V_OUTₐ sensed from the first output terminal OUTₐ during a normal counter clockwise operation of the DC motor L; and
- configuring the DC motor driver 200 or 200' in order to operate the first transistor M₁, the second transistor M₂, the third transistor M₃, and/or the fourth transistor M₄, that is, the full-bridge, in order to drive the DC motor L counter clockwise, for instance, by making the second transistor M₂ and the third transistor M₃ non-conductive and the first transistor M₁ and the fourth transistor M₄ conductive.

A further operative condition may be related to the monitoring of the first voltage V_OUTₐ sensed from the first output terminal OUTₐ of the DC motor driver 200 or 200' while the DC motor L is braking to the voltage VBAT, that is, the DC motor L brakes and decelerates since both of its terminals are coupled to the voltage VBAT.

Such further operative condition can be obtained by, in addition to setting the selection signal SEL:
- avoid operating the plurality of switches SW;
- setting the expected level for the monitoring signal P_{OUT} equal to a sequence (even composed by a single value) of levels related to the first voltage V_OUTₐ sensed from the first output terminal OUTₐ during a normal braking to the voltage VBAT operation of the DC motor L; and
- configuring the DC motor driver 200 or 200' in order to operate the first transistor M₁, the second transistor M₂, the third transistor M₃, and/or the fourth transistor M₄, that is, the full-bridge, in order to drive the DC motor L for braking to the voltage VBAT, for instance, by making the first transistor M₁ and the third transistor M₃ conductive and the second transistor M₂ and the fourth transistor M₄ non-conductive.

A further operative condition may be related to the monitoring of the first voltage V_OUTₐ sensed from the first output terminal OUTₐ of the DC motor driver 200 or 200' while the DC motor L is braking to ground GND, that is, the DC motor L brakes and decelerates since both of its terminals are coupled to ground GND.

Such further operative condition can be obtained by, in addition to setting the selection signal SEL:
- avoid operating the plurality of switches SW;
- setting the expected level for the monitoring signal P_{OUT} equal to a sequence (even composed by a single value) of levels related to the first voltage V_OUTₐ sensed from the first output terminal OUTₐ during a normal braking to ground GND operation of the DC motor L; and
- configuring the DC motor driver 200 or 200' in order to operate the first transistor M₁, the second transistor M₂, the third transistor M₃, and/or the fourth transistor M₄, that is, the full-bridge, in order to drive the DC motor L for braking to ground GND, for instance, by making the first transistor M₁ and the third transistor M₃ non-conductive and the second transistor M₂ and the fourth transistor M₄ conductive.

A first diagnostic condition may be related to the monitoring of the first voltage V_OUTₐ sensed from the first output terminal OUTₐ of the DC motor driver 200 or 200' while the DC motor driver is configured to perform fault detection operations and, in particular, a high-side fault detection operation.

Such first diagnostic condition can be obtained by, in addition to setting the selection signal SEL:
- avoid operating the plurality of switches SW;
- setting the expected level for the monitoring signal P_{OUT} equal to a sequence (even composed by a single value) of levels related to the expected first voltage V_OUTₐ sensed from the first output terminal OUTₐ during a high-side fault detection operation that do not detect anomalies or faults, for instance, such expected first voltage V_OUTₐ may be a signal set to the voltage VBAT; and
- configuring the DC motor driver 200 or 200' in order to operate the third transistor M₃, making it conductive.

It is noted that the diagnostic condition related to the high-side fault detection operation may be performed also by configuring the DC motor driver 200 or 200' in order to operate the first transistor M₁, making such first transistor M₁ conductive.

A further diagnostic condition may be related to the monitoring of the first voltage V_OUTₐ sensed from the first output terminal OUTₐ of the DC motor driver 200 or 200' while the DC motor driver is configured to perform fault detection operations and, in particular, a low-side fault detection operation.

Such further diagnostic condition can be obtained by, in addition to setting the selection signal SEL:
- operating the first pull-up impedance switch SW_PU₁, coupling the supply terminal at the voltage VBAT and the first node N₁;
- setting the expected level for the monitoring signal P_{OUT} equal to a sequence (even composed by a single value) of levels related to the expected first voltage V_OUTₐ sensed from the first output terminal OUTₐ during a low-side fault detection operation that do not detect anomalies or faults, for instance, such expected first voltage V_OUTₐ may be a signal set to the ground voltage GND; and
- configuring the DC motor driver 200 or 200' in order to operate the fourth transistor M₄, making it conductive, and the second transistor M₂, making it non-conductive.

A further diagnostic condition may be related to the monitoring of the first voltage V_OUTₐ sensed from the first output terminal OUTₐ of the DC motor driver 200 or 200' while the DC motor driver is configured to perform fault detection operations and, in particular, a fault detection operation performed during an off-state of such DC motor driver.

Such a condition can be obtained by, in addition to setting the selection signal SEL:
- operating the second pull-up impedance switch SW_PU₂, coupling the supply terminal at the voltage VBAT and the second node N₂;
- setting the expected level for the monitoring signal P_{OUT} equal to a sequence (even composed by a single value) of levels related to the expected first voltage V_OUTₐ sensed from the first output terminal OUTₐ during an off-state fault detection operation that do not detect anomalies or faults, for instance, such expected first voltage V_OUTₐ may be a signal set to the ground voltage GND; and
- configuring the DC motor driver 200 or 200' in order to make all the transistors M₁, M₂, M₃, and M₄ non-conductive.

Further conditions may be related to the monitoring of the second voltage V_OUT_{b} sensed from the second output terminal OUT_{b} of the DC motor driver 200 or 200'.

For instance, another operative condition may be related to the monitoring of such second voltage V_OUT_{b} sensed from the second output terminal OUT_{b} of the DC motor driver 200 or 200' while the DC motor L is operated clockwise.

Such operative condition can be obtained by:
- setting the selection signal SEL to indicate to couple the second input terminal of the selection unit PD_{a,b} to the output terminal of such selection unit PD_{a,b}, thus, indicating to provide as output the information related to the phase of the second output terminal OUT_{b}, for instance, by setting such selection signal SEL to a binary logic level equal to a low logic level;
- avoid operating the plurality of switches SW;
- setting the expected level for the monitoring signal P_{OUT} equal to a sequence (even composed by a single value) of levels related to the second voltage V_OUT_{b} sensed from the second output terminal OUT_{b} during a normal clockwise operation of the DC motor L; and
- configuring the DC motor driver 200 or 200' as in the condition related to the monitoring of the first voltage V_OUTₐ sensed from the first output terminal OUTₐ of the DC motor driver 200 or 200', such DC motor L being operated clockwise.

Even in this case, it is noted that other conditions described in the following that are related to the monitoring of the second voltage V_OUT_{b} sensed from the second output terminal OUT_{b} of the DC motor driver 200 or 200' comprise setting the selection signal SEL to indicate to couple the second input terminal of the selection unit PD_{a,b} to the output terminal of such selection unit PD_{a,b}, thus, indicating to provide as output the information related to the phase of the second output terminal OUT_{b}, for instance, by setting such selection signal SEL to a binary logic level equal to a low logic level.

Therefore, such setting operation of the selection signal SEL will be not repeated in the following.

A further operative condition may be related to the monitoring of the second voltage V_OUT_{b} sensed from the second output terminal OUT_{b} of the DC motor driver 200 or 200' while the DC motor L is operated counter clockwise.

Such operative condition can be obtained by, in addition to setting the selection signal SEL:
- avoid operating the plurality of switches SW;
- setting the expected level for the monitoring signal P_{OUT} equal to a sequence (even composed by a single value) of levels related to the second voltage V_OUT_{b} sensed from the second output terminal OUT_{b} during a normal counter clockwise operation of the DC motor L; and
- configuring the DC motor driver 200 or 200' as in the condition related to the monitoring of the first voltage V_OUTₐ sensed from the first output terminal OUTₐ of the DC motor driver 200 or 200', such DC motor L being operated counter clockwise.

A further operative condition may be related to the monitoring of the second voltage V_OUT_{b} sensed from the second output terminal OUT_{b} of the DC motor driver 200 or 200' while the DC motor L is braking to the voltage VBAT.

Such further operative condition can be obtained by, in addition to setting the selection signal SEL:
- avoid operating the plurality of switches SW;
- setting the expected level for the monitoring signal P_{OUT} equal to a sequence (even composed by a single value) of levels related to the second voltage V_OUT_{b} sensed from the second output terminal OUT_{b} during a normal braking to the voltage VBAT operation of the DC motor L; and
- configuring the DC motor driver 200 or 200' as in the condition related to the monitoring of the first voltage V_OUTₐ sensed from the first output terminal OUTₐ of the DC motor driver 200 or 200', such DC motor L being configured to brake to the voltage VBAT.

A further operative condition may be related to the monitoring of the second voltage V_OUT_{b} sensed from the second output terminal OUT_{b} of the DC motor driver 200 or 200' while the DC motor L is braking to ground GND.

Such further operative condition can be obtained by, in addition to setting the selection signal SEL:
- avoid operating the plurality of switches SW;
- setting the expected level for the monitoring signal P_{OUT} equal to a sequence (even composed by a single value) of levels related to the second voltage V_OUT_{b} sensed from the second output terminal OUT_{b} during a normal braking to ground GND operation of the DC motor L; and
- configuring the DC motor driver 200 or 200' as in the condition related to the monitoring of the first voltage V_OUTₐ sensed from the first output terminal OUTₐ of the DC motor driver 200 or 200', such DC motor L being configured to brake to ground GND.

A first diagnostic condition may be related to the monitoring of the second voltage V_OUT_{b} sensed from the second output terminal OUT_{b} of the DC motor driver 200 or 200' while the DC motor driver is configured to perform fault detection operations and, in particular, a high-side fault detection operation.

Such first diagnostic condition can be obtained by, in addition to setting the selection signal SEL:
- avoid operating the plurality of switches SW;
- setting the expected level for the monitoring signal P_{OUT} equal to a sequence (even composed by a single value) of levels related to the expected second voltage V_OUT_{b} sensed from the second output terminal OUT_{b} during a high-side fault detection operation that do not detect anomalies or faults, for instance, such expected second voltage V_OUT_{b} may be a signal set to the voltage VBAT; and
- configuring the DC motor driver 200 or 200' in order to operate the first transistor M₁, making it conductive.

It is noted that the condition related to the high-side fault detection operation may be performed also by configuring the DC motor driver 200 or 200' in order to operate the third transistor M₃, making such third transistor M₃ conductive.

A further diagnostic condition may be related to the monitoring of the second voltage V_OUT_{b} sensed from the second output terminal OUT_{b} of the DC motor driver 200 or 200' while the DC motor driver is configured to perform fault detection operations and, in particular, a low-side fault detection operation.

Such further diagnostic condition can be obtained by, in addition to setting the selection signal SEL:
- operating the second pull-up impedance switch SW_PU₂, coupling the supply terminal at the voltage VBAT and the second node N₂;
- setting the expected level for the monitoring signal P_{OUT} equal to a sequence (even composed by a single value) of levels related to the expected second voltage V_OUT_{b} sensed from the second output terminal OUT_{b} during a low-side fault detection operation that do not detect anomalies or faults, for instance, such expected second voltage V_OUT_{b} may be a signal set to the ground voltage GND; and
- configuring the DC motor driver 200 or 200' in order to operate the fourth transistor M₄, making it non-conductive, and the second transistor M₂, making it conductive.

A further diagnostic condition may be related to the monitoring of the second voltage V_OUT_{b} sensed from the second output terminal OUT_{b} of the DC motor driver 200 or 200' while the DC motor driver is configured to perform fault detection operations and, in particular, a fault detection operation performed during an off-state of such DC motor driver.

Such further diagnostic condition can be obtained by, in addition to setting the selection signal SEL:
- operating the first pull-up impedance switch SW_PU₁, coupling the supply terminal at the voltage VBAT and the first node N₁;
- setting the expected level for the monitoring signal P_{OUT} equal to a sequence (even composed by a single value) of levels related to the expected second voltage V_OUT_{b} sensed from the second output terminal OUT_{b} during an off-state fault detection operation that do not detect anomalies or faults, for instance, such expected second voltage V_OUT_{b} may be a signal set to the ground voltage GND; and
- configuring the DC motor driver 200 or 200' in order to make all the transistors M₁, M₂, M₃, and M₄ non-conductive.

Further diagnostic conditions may also be related to the monitoring of the DC motor driver 200 or 200' during a stand by state.

It is noted that if the monitoring functions are not to be provided in cases where the pull-up impedance switches are operated, such plurality of switches SW may also be absent.

In such a case, the first voltage V_OUTₐ sensed from the first output terminal OUTₐ and the second voltage V_OUT_{b} sensed from the second output terminal OUT_{b} are provided directly to the first input terminal of the first comparator AMP₁ and to the first input terminal of the second comparator AMP₂, respectively.

It is also noted that, based on the monitoring functions considered, such plurality of switches SW may comprise only a single pull-up impedance switch.

Solutions as described herein facilitate achieving a circuit for monitoring phases of a Direct Current motor driver, for instance, by monitoring the states of its output signals OUTₐ and OUT_{b} via the monitoring signal P_{OUT} in order to monitor a phase of a load coupled thereto, for example, the phase of a DC motor L, such DC motor driver being configured to drive the DC motor via a first and a second terminal.

The circuit according to solution as disclosed herein comprises:
- a first comparison circuitry configured to receive a first voltage of the first terminal and a threshold voltage, to compare such first voltage with such threshold voltage, obtaining a first comparison voltage, and to provide such first comparison voltage to a selection circuitry;
- a second comparison circuitry configured to receive a second voltage of the second terminal and the threshold voltage, to compare such second voltage with such threshold voltage, obtaining a second comparison voltage, and to provide such second comparison voltage to the selection circuitry; and
- the selection circuitry configured to receive the first comparison voltage, the second comparison voltage, and a selection signal indicating to select the first comparison voltage or the second comparison voltage, and to select, based on such selection signal, such first comparison voltage or such second comparison voltage as monitored voltage signal.

In embodiments of the circuit as described herein, such first comparison circuitry may be configured to receive such first voltage via a first node and such second comparison circuitry may be configured to receive such second voltage via a second node.

Thus, such circuit may comprise:
- a first switch coupled between such first node and a supply terminal and/or a second switch coupled between such second node and such supply terminal, such first switch and such second switch being configured to perform pull-up operations; and/or
- a first pull-down impedance coupled between such first node and a ground terminal and/or a second pull-down impedance coupled between such second node and such ground terminal.

It is noted that solutions as described herein also apply to a DC driver, for instance, the DC motor driver 200 of Figure 2, in particular comprising an H-bridge, configured to drive a load L, in particular a DC motor, via a first terminal, that is, the first output terminal OUTₐ, and a second terminal, that is, the second output terminal OUT_{b}, coupled to respective load terminals, wherein such DC driver 200 comprises the circuit 30.

It is further noted that such DC driver is configured to switch a polarity applied to the terminals of the load L.

It is noted that solutions as described herein also apply to a method for monitoring phases of a Direct Current, DC, driver 200 or 200' through the circuit 30 or 30' respectively, such DC driver 200 or 200' being configured to drive a load L, for instance, a DC motor, via a first terminal, for instance, the first output terminal OUTₐ, and a second terminal, for instance, the second output terminal OUT_{b}, coupled to respective load terminals by switching a polarity applied thereto.

Such method comprises:
- receiving, by a first comparison circuitry, for instance, the first comparator AMP₁, a first voltage V_OUTₐ of the first terminal, for instance, the first output terminal OUTₐ, and a threshold voltage Vₜₕ;
- comparing, via such first comparison circuitry AMP₁, such first voltage V_OUTₐ with such threshold voltage Vₜₕ, obtaining a first comparison voltage;
- providing, via such first comparison circuitry AMP₁, such first comparison voltage to a selection circuitry, for instance, the selection unit PD_{a,b};
- receiving, by a second comparison circuitry, for instance, the second comparator AMP₂, a second voltage V_OUT_{b} of the second terminal, for instance, the second output terminal OUT_{b}, and such threshold voltage Vₜₕ;
- comparing, via such second comparison circuitry AMP₂, such second voltage V_OUT_{b} with such threshold voltage Vₜₕ, obtaining a second comparison voltage;
- providing, via such second comparison circuitry AMP₂, such second comparison voltage to the selection circuitry PD_{a,b};
- receiving, by the selection circuitry PD_{a,b}, the first comparison voltage, the second comparison voltage, and a selection signal SEL indicating to select either the first comparison voltage or the second comparison voltage; and
- selecting, via the selection circuitry PD_{a,b} and based on such selection signal SEL, such first comparison voltage or such second comparison voltage as a monitored voltage signal, for instance, the monitoring signal P_{OUT}.

In embodiments of solutions described herein, such operation of receiving, by the first comparison circuitry AMP₁, the first voltage V_OUTₐ may be performed via a first node N₁, and such operation of receiving, by the second comparison circuitry AMP₂, the second voltage V_OUT_{b} may be performed via a second node N₂.

In such a case, the method may comprise performing pull-up operations via a first switch, for instance, the first pull-up impedance switch SW_PU₁, coupled between such first node N₁ and a supply terminal VBAT and/or a second switch, for instance, the second pull-up impedance switch SW_PU₂, coupled between such second node N₂ and such supply terminal VBAT.

In embodiments of solutions described herein, such method may comprise driving, via such selection circuitry PD_{a,b} and based on a comparison voltage selected out of such first comparison voltage and such second comparison voltage, a transistor, for instance, the fifth transistor M₅, via its control terminal, such transistor M₅ having:
- its current source terminal coupled to the ground terminal Vss; and
- its current sinking terminal configured to provide the monitored voltage signal P_{OUT}.

Thus, solutions as described herein facilitate improving the monitoring of devices used for driving DC motors, that is, DC motor drivers, facilitating performing monitoring operations both during on-states and during off-states of such DC motor drivers in order to increase a functional safety of such devices.

In such a way, solutions as described herein can have a higher ASIL-B metric at system level and, if the solution is integrated in the DC motor driver 200 as in Figure 2 (therefore, if such DC motor driver 200 is implemented without discrete components), solutions as described herein can also reduce the external circuitry requested for performing the monitoring function.

In addition, solutions as described herein can facilitate saving costs and area of the PCB ("Printed Circuit Board"), also in case of an implementation with discrete components as in Figure 3, such advantages being a result of a higher integration level.

It is noted that, if the plurality of switches SW is present, the PCB area can be even further reduced since such plurality of switches SW facilitate, without using additional components, testing various operative and fault detection conditions, allowing a more detailed diagnostic of the power stages as every output power can be checked.

Without prejudice to the underlying principles, the details and the embodiments may vary, even significantly, with respect to what has been described by way of example only without departing from the scope of the embodiments.

The extent of protection is determined by the annexed claims.

## Claims

1. Circuit (30; 30') for monitoring phases of a Direct Current, DC, driver (200; 200'), said DC driver (200; 200') being configured to drive a load (L) via a first terminal (OUTₐ) and a second terminal (OUT_{b}) coupled to respective load (L) terminals switching a polarity there applied;
wherein said circuit (30; 30') comprises:
- a first comparison circuitry (AMP₁) configured to receive a first voltage (V_OUTₐ) of the first terminal (OUTₐ) and a threshold voltage (Vₜₕ), to compare said first voltage (V_OUTₐ) with said threshold voltage (Vₜₕ), obtaining a first comparison voltage, and to provide said first comparison voltage to a selection circuitry (PD_{a,b});
- a second comparison circuitry (AMP₂) configured to receive a second voltage (V_OUT_{b}) of the second terminal (OUT_{b}) and said threshold voltage (Vₜₕ), to compare said second voltage (V_OUT_{b}) with said threshold voltage (Vₜₕ), obtaining a second comparison voltage, and to provide said second comparison voltage to the selection circuitry (PD_{a,b}); and
- the selection circuitry (PD_{a,b}) being configured to receive the first comparison voltage, the second comparison voltage, and a selection signal (SEL) indicating to select either the first comparison voltage or the second comparison voltage, and to select, based on said selection signal (SEL), said first comparison voltage or said second comparison voltage as a monitored voltage signal (P_{OUT}).

2. The circuit (30; 30') according to claim 1, wherein:
said first comparison circuitry (AMP₁) is configured to receive said first voltage (V_OUTₐ) via a first node (N₁); and
said second comparison circuitry (AMP₂) is configured to receive said second voltage (V_OUT_{b}) via a second node (N₂);
wherein said circuit (30; 30') comprises:
- a first switch (SW_PU₁) coupled between said first node (N₁) and a supply terminal (VBAT) and/or a second switch (SW_PU₂) coupled between said second node (N₂) and said supply terminal (VBAT), said first switch (SW_PU₁) and said second switch (SW_PU₂) being configured to perform pull-up operations; and/or
- a first pull-down impedance (PD₁) coupled between said first node (N₁) and a ground terminal (Vss) and/or a second pull-down impedance (PD₂) coupled between said second node (N₂) and said ground terminal (Vss).

3. The circuit (30; 30') according to claim 2, wherein said first switch (SW_PU₁) and said second switch (SW_PU₂) integrate a protection circuitry, in particular, wherein said first switch (SW_PU₁) and said second switch (SW_PU₂) are Vertical Intelligent Power, VIPower switches.

4. The circuit (30; 30') according to any of the previous claims, wherein said selection circuitry (PD_{a,b}) is configured to drive, based on a comparison voltage selected out of said first comparison voltage and said second comparison voltage, a transistor (M₅) via its control terminal, said transistor (M₅) having:
- its current source terminal coupled to a ground terminal (Vss); and
- its current sinking terminal configured to provide the monitored voltage signal (P_{OUT}).

5. The circuit (30; 30') according to any of the previous claims, wherein said monitored voltage signal (P_{OUT}) is provided to a control unit, in particular, a control unit external to the DC driver (200; 200'), said control unit being configured to, based on a current operation mode of the DC driver (200; 200'):
- set the selection signal (SEL) to indicate to select the first comparison voltage or the second comparison voltage;
- retrieve an expected monitored voltage level, in particular a binary level;
- compare the received monitored voltage signal (P_{OUT}) with a verification voltage threshold, obtaining a comparison monitored voltage level, in particular a binary level, indicating if the received monitored voltage signal is higher or lower than the verification voltage threshold;
- if the comparison monitored voltage level is equal to the expected monitored voltage level, classify the current operation mode of the DC driver (200; 200') as not anomalous; and
- if the comparison monitored voltage level is different from the expected monitored voltage level, classify the current operation mode of the DC driver (200; 200') as anomalous.

6. The circuit (30; 30') according to claim 5 in combination with claim 2, wherein said control unit is configured to operate, based on the current operation mode of the DC driver (200; 200') the first switch (SW_PU₁) and/or the second switch (SW _PU₂) for performing pull-up operations.

7. The circuit (30; 30') according to any of the previous claims, wherein said DC driver (200; 200') comprises:
- a H-bridge comprising a plurality of transistors (M₁, M₂, M₃, M₄); and
- a DC driver control unit (202) configured to drive, via respective control terminals, said plurality of transistors (M₁, M₂, M₃, M₄) comprised in the H-bridge.

8. The circuit (30; 30') according to any of the previous claims, wherein said load (L) is a DC motor.

9. The circuit (30; 30') according to any of the previous claims, wherein:
- said circuit (30) is integrated in the DC driver (200), in particular, in a DC driver control unit (202); or
- said circuit (30') is external to the DC driver (200') and, in particular, is implemented using discrete components.

10. A DC driver (200), in particular comprising an H-bridge, configured to drive a load (L), in particular a DC motor, via a first terminal (OUTₐ) and a second terminal (OUT_{b}) coupled to respective load (L) terminals switching a polarity there applied, wherein said DC driver (200) comprises a circuit (30) according to any of claims 1 to 8.

11. Method for monitoring phases of a Direct Current, DC, driver (200; 200') through a circuit (30; 30') according to any of the claims 1 to 9, said DC driver (200; 200') being configured to drive a load (L) via a first terminal (OUTₐ) and a second terminal (OUT_{b}) coupled to respective load (L) terminals switching a polarity there applied;
said method comprises:
- receiving, by a first comparison circuitry (AMP₁), a first voltage (V_OUTₐ) of the first terminal (OUTₐ) and a threshold voltage (Vₜₕ);
- comparing, via said first comparison circuitry (AMP₁), said first voltage (V_OUTₐ) with said threshold voltage (Vₜₕ), obtaining a first comparison voltage;
- providing, via said first comparison circuitry (AMP₁), said first comparison voltage to a selection circuitry (PD_{a,b});
- receiving, by a second comparison circuitry (AMP₂), a second voltage (V_OUT_{b}) of the second terminal (OUT_{b}) and said threshold voltage (Vₜₕ);
- comparing, via said second comparison circuitry (AMP₂), said second voltage (V_OUT_{b}) with said threshold voltage (Vₜₕ), obtaining a second comparison voltage;
- providing, via said second comparison circuitry (AMP₂), said second comparison voltage to the selection circuitry (PD_{a,b});
- receiving, by the selection circuitry (PD_{a,b}), the first comparison voltage, the second comparison voltage, and a selection signal (SEL) indicating to select either the first comparison voltage or the second comparison voltage; and
- selecting, via the selection circuitry (PD_{a,b}) and based on said selection signal (SEL), said first comparison voltage or said second comparison voltage as a monitored voltage signal (P_{OUT}).

12. The method according to claim 11, wherein:
said operation of receiving, by the first comparison circuitry (AMP₁), the first voltage (V_OUTₐ) is performed via a first node (N₁); and
said operation of receiving, by the second comparison circuitry (AMP₂), the second voltage (V_OUT_{b}) is performed via a second node (N₂);
wherein said method comprises performing pull-up operations via a first switch (SW_PU₁) coupled between said first node (N₁) and a supply terminal (VBAT) and/or a second switch (SW_PU₂) coupled between said second node (N₂) and said supply terminal (VBAT).

13. The method according to claim 11 or claim 12, comprising driving, via said selection circuitry (PD_{a,b}) and based on a comparison voltage selected out of said first comparison voltage and said second comparison voltage, a transistor (M₅) via its control terminal, said transistor (M₅) having:
- its current source terminal coupled to a ground terminal (Vss); and
- its current sinking terminal configured to provide the monitored voltage signal (P_{OUT}).
